# EUROPÄISCHE PATENTSCHRIFT

(11) **EP 0 651 684 B1**
(45) Veröffentlichungstag und Bekanntmachung des Hinweises auf die Patenterteilung: **22.05.1996**
(21) Anmeldenummer: 93912624.9
(22) Anmeldetag: 25.06.1993
(51) Int. Cl.: B23K 1/005, B23K 1/008, F27B 9/06, H05K 3/34

(54) **VORRICHTUNG UND VERFAHREN ZUM AUFLÖTEN VON BAUELEMENTEN AUF PLATINEN**
APPARATUS AND PROCESS FOR SOLDERING COMPONENT ONTO BOARDS
PROCEDE ET DISPOSITIF DE SOUDAGE DE COMPOSANTS SUR DES PLATINES

(30) Priorität: 22.07.1992 DE 4224095; 03.02.1993 DE 4302976
(43) Veröffentlichungstag der Anmeldung: 10.05.1995
(73) Patentinhaber: ROBERT BOSCH GMBH, 70442 Stuttgart (DE)
(72) Erfinder: HARTMANN, Horst-Joachim, D-7000 Stuttgart 31 (DE); SAILE, Peter, D-7000 Stuttgart (DE)
(86) Internationale Anmeldenummer: DE9300557
(87) Internationale Veröffentlichungsnummer: WO9402279

(56) Entgegenhaltungen:
- EP-A- 0 163 259
- EP-A- 0 315 762
- EP-A- 0 346 117
- DE-A- 3 806 753
- US-A- 3 588 425
- PATENT ABSTRACTS OF JAPAN vol. 014, no. 375 (M-1010)14. August 1990 & JP-A-21 37 667 ( MATSUSHITA ELECTRIC IND. CORP.) 25 May 1990
- PATENT ABSTRACTS OF JAPAN vol. 13, no. 360 (M-858)(3708) 11. August 1989 & JP-A-11 18 370 ( MATSUSHITA ELECTRIC IND. CO LTD ) 10 May 1989
- ELECTRONIC PACKAGING AND PRODUCTION. Bd. 31, Nr. 11, November 1991, NEWTON, MASSACHUSETTS US Seiten 110 - 112 , XP000234073 W.H.DOWN 'Achieving consistency in IR reflow'

## Beschreibung

### Stand der Technik

Die Erfindung betrifft eine Vorrichtung gemäß dem Oberbegriff der Ansprüche 1 und 2 und ein Verfahren gemäß dem Oberbegriff der Ansprüche 9 und 10 zum Auflöten von Bauelementen auf Platinen (siehe JP-A-2-137667). Bei bekannten Lötvorrichtungen, sogenannten Reflowlötöfen, werden die Platinen vor dem Lötvorgang auf den für die Bauelemente vorgesehenen Plätzen mit Lotpaste bedruckt, danach die Bauelemente mit ihren Anschlüssen auf diese Plätze aufgebracht und in einem anschließenden Erwärmungsprozeß die Lotpaste aufgeschmolzen, wodurch eine dauerhafte Verbindung zwischen den Bauelementen und der Platine hergestellt wird. Der Wärmeeinbringungsprozeß ist dabei so gestaltet, daß die Platine samt den Bauelementen linear bis kurz unterhalb der Schmelztemparatur des Lotes erwärmt, dann kurzfristig über die Schmelztemperatur erhitzt und möglichst rasch wieder abgekühlt wird.

Aufgrund unterschiedlicher Masse/Oberfläche-Verhältnisse freier Platinenbereiche und Stellen mit großvolumigen Bauelementen bzw. hoher Bauteildichte kann sich bei der Erwärmung innerhalb einer Platine ein Temperaturunterschied ergeben, der unter Umständen dazu führt, daß Randbereiche der Platine schon durch Überhitzung zerstört werden, während die Bereiche mit großvolumigen Bauelementen bzw. hoher Bauteildichte die Schmelztemperatur des Lotes noch nicht erreicht haben. Es ist hierzu bereits bekannt, die Platine langsam aufzuheizen und somit durch Wärmeleitung zwischen heißen und kalten Stellen auf der Platine über einen längeren Zeitraum einen Temperaturausgleich zu schaffen. Dies ist jedoch unbefriedigend mit Blick auf eine optimale Ausnutzung der Anlagenkapazität. Ferner ist es durch die DE-OS 38 06 753 bekannt, mit einem Sensor bzw. einer Bilderkennungseinrichtung die Platine abzutasten und gezielt einzelnen Bereichen Wärme zuzuführen. Dieses System ist jedoch aufwendig und entsprechend störanfällig und deshalb für Platinenserien, die in großer Stückzahl gefertigt werden, nicht geeignet.

### Vorteile der Erfindung

Erfindungsgemäße Vorrichtungen und Verfahren mit den Merkmalen der Ansprüche 1, 2, 9 und 10 haben demgegenüber den Vorteil, daß an der Platinenoberfläche weniger Strahlung absorbiert wird, als an den Seitenwänden der großvolumigen Bauteile bzw. in den Bereichen mit hoher Bauteildichte. Auf diese Weise wird erreicht, daß die Wärme genau dort zugeführt wird, wo sie benötigt wird.

Die kreuzweise Anordnung der sich längs bzw. quer erstreckenden Infrarotstrahler ermöglicht in einfacher Weise, jeden Punkt bzw. jede senkrechte Wand auf der Platinenoberfläche gleichermaßen zu erwarmen.

Durch die in den Unteransprüchen aufgeführten Maßnahmen sind vorteilhafte Ausgestaltungen der Erfindung nach dem Hauptanspruch möglich. Insbesondere bewirkt eine Schrägstellung, bei der die Achse der Strahlrichtung der Infrarotstrahler mit der Platinennormalen einen Winkel zwischen 45 und 75 Grad, vorzugsweise einen Winkel von 65 Grad, einschließt, daß den senkrecht auf der Platine stehenden Wänden eine größtmögliche Strahlungsleistung zugeführt wird. Das Anbringen eines rückseitigen Reflektors an die Infrarotstahler vermindert Abstrahlverluste und ermöglicht ferner bei entsprechender Formgebung des Reflektors, den Strahlkegel zu variieren, insbesondere kann eine homogene Intensitätsverteilung über der Platinenoberfläche erreicht werden.

Der Einsatz sehr heißer Quarzstrahler bewirkt einen vorteilhaften Strahlungsenergietransport, welcher unabhängig von der Platinentemperatur ist. Ferner lassen sich solche Quarzstrahler schnell und einfach regeln, so daß die Vorrichtung rasch aufgeheizt und kurzfristig eingeregelt werden kann.

Eine gleichmäßige Temperaturverteilung über der Platinenoberfläche kann vorteilhaft dadurch erreicht werden, daß mittels eines Gebläses ein Gas, vorzugsweise ein inertes Gas, über die Platinenoberfläche geführt wird. Die Platine selbst kann gegen Überhitzung dadurch geschützt werden, daß sie beispielsweise von unten mit einem Gas vorbestimmter Temperatur gekühlt wird. Die großen, kälteren Bauteile auf der Oberseite bleiben von dieser Wärmeabfuhr unberührt, wodurch der Temperaturunterschied besonders vorteilhaft zwischen der Platine und den großen Bauteilen minimiert wird. In manchen Fällen kann es günstig sein, die Platinenunterseite mit vorgeheiztem Gas anzublasen, wobei der Grundgedanke der Warmeabfuhr auch hier gültig ist.

Um unkontrollierte Beiträge zum Wärmetransport zu verhindern, ist es von Vorteil, die Wände der Vorrichtung bzw. die Transporteinrichtung auf einer konstanten, vorbestimmten Temperatur zu halten.

Insbesondere beim Einstellen der Vorrichtung ist es von Vorteil, wenn auf der Platine mindestens ein die Temperatur der Platine erfassender Sensor vorgesehen ist, mit dem in Verbindung mit den schnell regelbaren Quarzstrahlern eine Echtzeitregelung aufgebaut werden kann und so mit nur einem Platinendurchlauf die neuen Betriebsparameter, wie Transportgeschwindigkeit, Leistung der Infrarotstrahler, Einblasen eines heißen, bzw. kalten Gases usw., bestimmbar sind. Dabei kann aus den gemessenen Werten der Vorwärmzone analytisch auf die Regelparameter der Lötzone geschlossen werden.

Durch die beanspruchten Verfahren wird es möglich, die Vorrichtung einfach und schnell an einen bestimmten Platinentyp anzupassen, das heißt, die Prozeßparameter, wie Strahlungsleistung und Transportgeschwindigkeit, festzulegen. Dabei ist es von Vorteil, wenn die Vorrichtung ein homogenes Strahlungsfeld aufweist und die Wärme verstärkt an den Wandbereichen der zu verlötenden Bauteile zugeführt wird; es ist jedoch nicht zwingend erforderlich.

Werden auf der Meßplatine mindestens zwei Temperatursensoren, möglichst an den Orten höchster und niedersten Temperatur angeordnet, läßt sich auf diese Weise die Temperaturdifferenz innerhalb einer Platine bestimmen, wodurch auf zusätzliche Maßnahmen, wie beispielsweise Anblasen der Platinenunterseite mit Gas vorbestimmter Temperatur, geschlossen werden kann.

Wird die Strahlungsleistung von einem in der Vorrichtung angeordneten Sensor aufgenommen, kann die tatsächliche Strahlungsleistung bestimmt werden, frei von Einflüssen, wie beispielsweise Wirkungsgrad oder Anordnung der Infrarotstrahler.

### Zeichnung

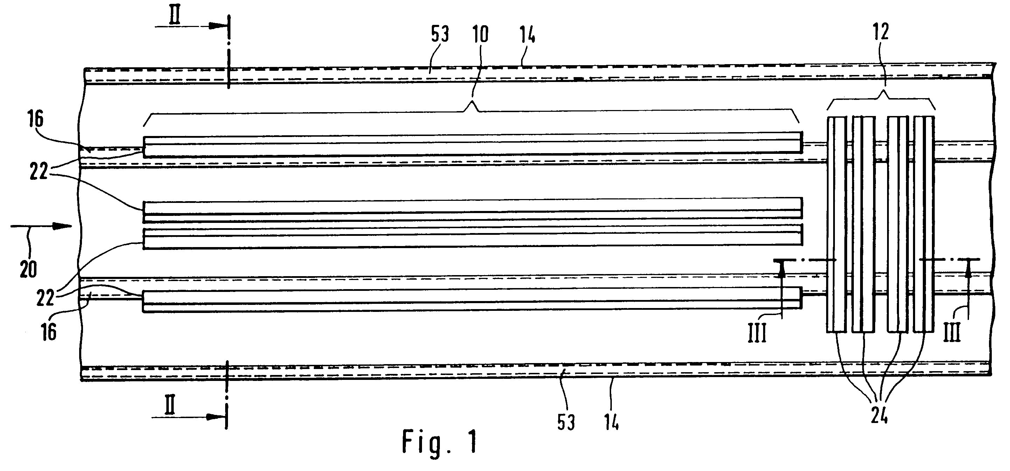

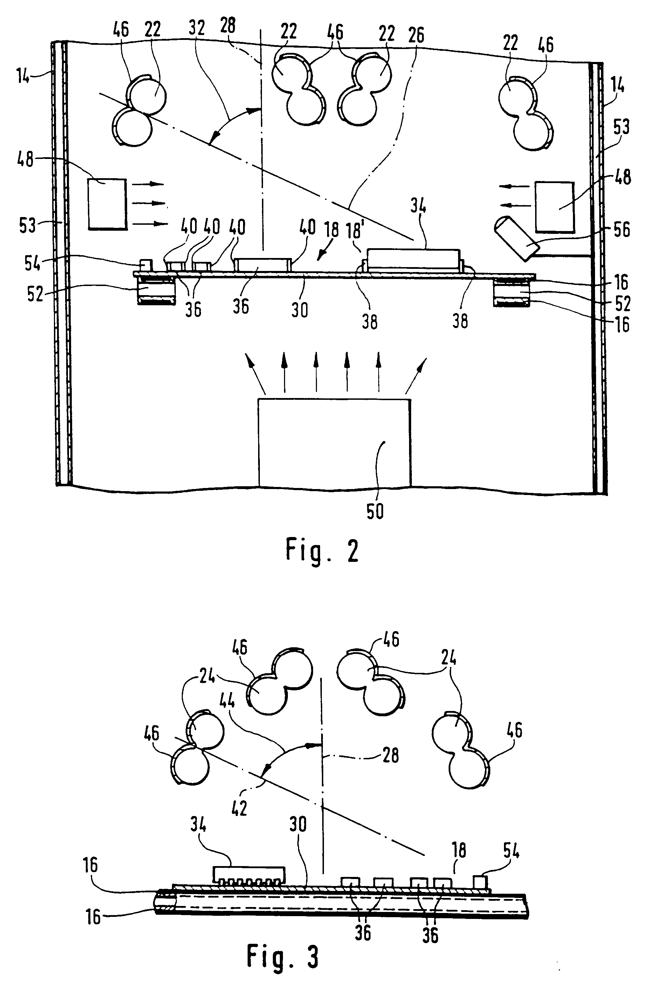

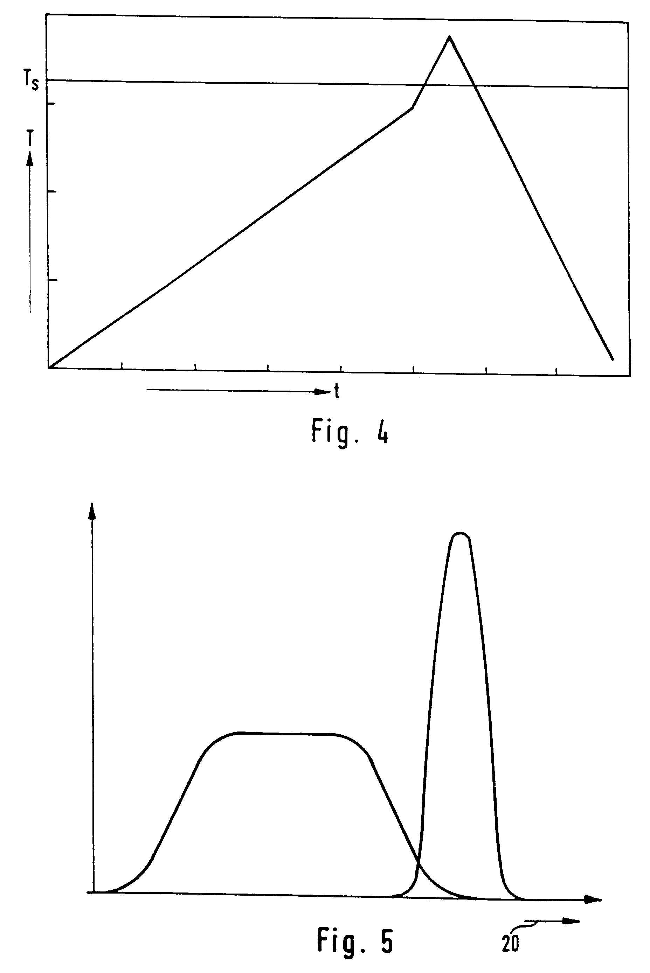

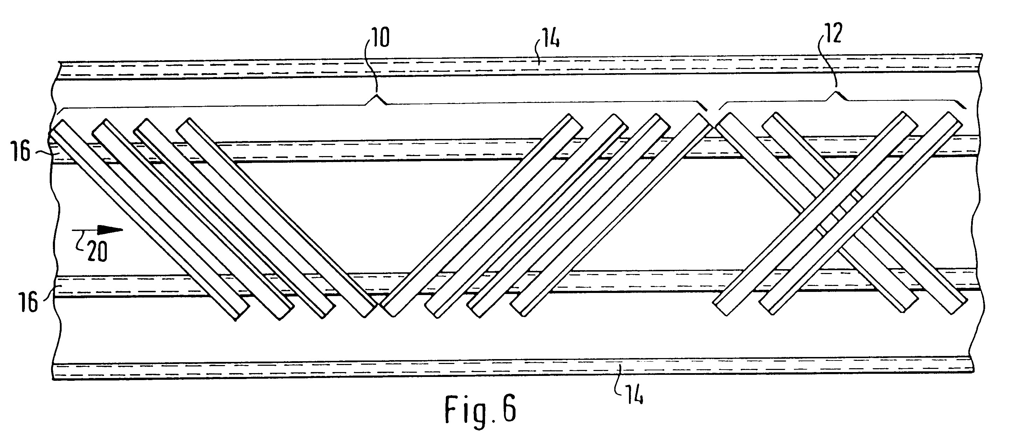

In der Zeichnung sind zwei Auführungsbeispiele dargestellt und in der nachfolgenden Beschreibung unter Angabe weiterer Vorteile beschrieben. Es zeigen Figur 1 eine Ansicht des ersten Ausführungsbeispiels von oben ohne zu verlötende Platine, Figur 2 einen Schnitt gemäß Linie II/II in Figur 1 und Figur 3 einen Schnitt gemäß Linie III/III in Figur 1, jeweils mit eingelegter Platine. In Figur 4 ist ein typisches Temperaturprofil eines Lötvorganges und in Figur 5 eine Strahlungsleistungsverteilung einer erfindungsgemäßen Vorrichtung gezeigt. Figur 6 zeigt eine Ansicht des zweiten Ausführungsbeispiels von oben ohne zu verlötende Platine.

### Beschreibung

In Figur 1 ist das Prinzip eines Reflowofens gemäß dem ersten Ausführungsbeispiel mit einer Vorwärmzone 10 und einer Lötzone 12 innerhalb begrenzender Wände 14 von oben gezeigt. Eine Transporteinrichtung, bestehend aus zwei Transportbändern 16, erstreckt sich zwischen den Wänden 14 durch die Vorwärmzone 10 und die Lötzone 12 hindurch und transportiert aufgelegte Schaltungsplatinen 18 in Pfeilrichtung 20. In der Vorwärmzone 10 sind über den Transportbändern 16 sich parallel zu den Transportbändern erstreckende Infrarotstrahler 22 angeordnet. In der Lötzone 12 sind über den Transportbändern 16 sich quer zu den Transportbändern 16 erstreckende Infrarotstrahler 24 angeordnet.

Gemäß dem zweiten Ausführungsbeispiel (Figur 6) sind in der Vorwärmzone 10 beziehungsweise in der Lötzone 12 Infrarotstrahler 60, 62, beziehungsweise 64, 66 über den Transportbändern 16 angeordnet, die mit der Transportrichtung 20 einen Winkel von vorzugsweise 45 Grad einschließen. Die Infrarotstrahler 60 und 62, beziehungsweise 64 und 66 sind so angeordnet, daß sie einen Winkel von näherungsweise 90 Grad einschließen, wobei, wie in der Vorwärmzone 10 gezeigt, die Infrarotstrahler 60, 62 hintereinander oder, wie in der Lötzone 12 gezeigt, die Infrarotstrahler 64, 66 übereinander liegen können. Es ist auch denkbar daß alle Infrarotstrahler 60, 62, beziehungsweise 64, 66, einer Zone 10, beziehungsweise 12, parallel zueinander und im Winkel zu den Infrarotstrahlern der anderen Zone angeordnet sind.

Die Infrarotstrahler 22, 60, 62 der Vorwärmzone 10 sind so justiert, daß ihre Hauptstrahlachse 26 (Figur 2) schräg auf die Oberflächen der darunter durchgeführten Schaltungsplatinen 18 weist. Mit der Platinennormalen 28, die senkrecht auf dem Platinenboard 30 steht, schließt die Hauptstrahlachse 26 einen Winkel 32 zwischen 45 und 75 Grad, vorzugsweise von 65 Grad ein. Diese Schrägstellung bewirkt, daß die Strahlungsintensität auf die Oberfläche der auf die Schaltungsplatine 18 aufzulötenden Bauteile, insbesondere integrierte Schaltkreise 34 oder SMD-Bauteile 36, kleiner ist, als auf die Seitenfläche dieser Bauteile. Es werden somit bevorzugt die Berührungsstellen zwischen den Anschlußbeinen 38 der ICs 34 und den Kontaktstellen auf dem Platinenbord 30 bzw. die Kontaktflächen 40 der SMD-Bauteile 36 und der Kontaktstelle auf dem Platinenbord 30 erwärmt. Daraus resultiert eine geringere Temperaturdifferenz zwischen großen Bauteilen und freien Platinenbereichen, wodurch die thermische Belastung der Platinenbereiche und den elektronischen Bauteile verringert und deshalb die Strahlleistung erhöht und die Aufheizzeit in der Vorwärmzone 10 verkürzt werden kann.

Die Infrarotstrahler 22, 60, 62 sind gestaffelt und so angeordnet, daß auch nebeneinander sitzende Bauteile in ausreichendem Maße erwärmt werden, ohne daß eine Schattenwirkung auftritt.

In der Lötzone 12 (Figur 3), in der eine rasche Erwärmung der Kontaktstellen 38, 30 und 40, 30 bis über den Schmelzpunkt des Lotes erfolgt, sind die Infrarotstrahler 24, 64, 60 quer beziehungsweise im Winkel zur Transportrichtung 20 angeordnet und weisen mit ihrer Hauptstrahlachse 42 schräg auf die Schaltungsplatine 18, wobei die Hauptstrahlachse 42 mit der Platinennormalen 28 ebenfalls einen Winkel 44 zwischen 45 und 75 Grad, bevorzugt einen Winkel von 65 Grad einschließt. Dadurch werden Bereiche, die in der Vorwärmzone 10 eher tangential angestrahlt wurden, hier direkt getroffen wodurch eine intensive Erwärmung erfolgt. Auch hier sind die Infrarotstrahler 24 gestaffelt angeordnet, um eine Schattenwirkung zu vermeiden.

Durch die spezielle Anordnung der Infrarotstrahler 22, 60, 62 und 24, 64, 66 in der Vorwärm- und Lötzone 10, 12 ist es möglich, sehr heiße, d.h. mit einer Temperatur von mehr als 2000 Grad Celcius strahlende, Quarzstrahler einzusetzen, die einen Strahlungsenergietransport bewirken, welcher in erster Näherung unabhängig von der momentanen Platinentemperatur ist. Die Infrarotstrahler 22, 24, 60, 62, 64, 66 weisen an ihrer Rückseite Goldreflektoren 46 auf, um die Strahlungsleistung in Richtung der Platinen zu erhöhen. Die Form der Reflektoren 46 ist dabei so gewählt, daß eine optimale, homogene Ausleuchtung der Platinenoberfläche erzielt wird.

In einer besonderen Ausgestaltung weist der Reflowofen ein Zuluftsystem 48 auf, zum Beispiel in der Form von Ventilatoren oder eines oder mehrerer Gebläse, mittels dem heißes Gas über die zu verlötenden Bereiche geführt wird. Das Zuluftsystem 48 muß dabei nicht zwangsweise seitlich der Transportbänder 16 angeordnet sein, wie in Figur 2 gezeigt. Wichtig ist hierbei nur, daß durch die erzeugte Konvektion eine möglichst homogene Temperaturverteilung über der Platinenoberfläche erreicht wird.

Ein weiteres Zuluftsystem 50 zur Zuführung eines kühlenden Gasstromes ist beispielsweise unterhalb der Transportbänder 16 angeordnet, das auf diese Weise die Unterseite der Schaltungsplatinen 18 kühlt.

Als heizendes oder kühlendes Gas kann auch inertes Gas oder Gas mit Flußmitteleigenschaften eingesetzt werden, das dann aus externen Behältern unter Druck zugeführt wird. Um mit möglichst wenig einzublasendem Gas auszukommen, erfolgt die Zuführung unter Ausnützung des Venturi-Prinzips. Dabei saugt das durch eine Venturi-Düse einströmende Frischgas sich bereits im Innenraum befindendes Gas an und bewirkt so eine Umwälzung innerhalb einer Zone.

Die Transportbänder 16, auf deren jeweils oberem Strang die Schaltungsplatinen 18 aufliegen, werden je auf einem Hohlprofil 52 geführt, durch dessen hohlen Querschnitt eine temperierte Flüssigkeit strömt und so die Transportbänder 16 auf einer vorbestimmten Temperatur halten. Ferner sind die Wände 14 mit flüssigkeitsdurchströmten Hohlräumen 53 versehen, so daß auch diese auf einer vorbestimmten Temperatur gehalten werden können. Diese Maßnahmen erweisen sich insbesondere dort als vorteilhaft, wo die Vorrichtung unter extremen oder wechselnden Bedingungen betrieben werden muß.

Insbesondere zum Einstellen des Temperaturprofils, d.h. der Erwarmung pro Zeit der Schaltungsplatinen 18, als auch zur Kontrolle und Regelung der Leistung der Infrarotstrahler 22, 24, 60, 62, 64, 66 der Geschwindigkeit der Transportbänder 16 oder anderen Parametern ist auf einer Platine 18, im folgenden Meßplatine 18' genannt, mindestens ein die Temperatur aufnehmender Sensor 54 angeordnet. Der Sensor 54 wird bevorzugt an Problemzonen, wie zum Beispiel dem Rand der Schaltungsplatine 18 oder in der Nähe großdimensionierter Bauteile, angebracht. Es können auch mehrere über die Meßplatine 18' verteilt angeordnete Sensoren 54 vorgesehen sein. Ferner ist zur Aufnahme der Strahlungsleistung, insbesondere in der Vorwärmzone 10, ein weiterer Sensor 56, vorzugsweise ein Infrarot-Detektor, angeordnet.

Bei einem typischen Lötprozeß durchläuft eine auf den Transportbändern 16 aufliegende, mit Bauelementen 34, 36 bestückte Schaltungsplatine 18 mit vorbestimmter Geschwindigkeit die Vorwärmzone 10 und unterliegt der darin vorherrschenden Strahlungsleistungsdichte (Figur 5). Dabei erhöht sich die Temperatur der Platine, insbesondere der Kontaktstellen 38, 30 bzw. 40, 30 näherungsweise linear bis knapp unter die Schmelztemperatur Tₛ des verwendeten Lotes (Figur 4). In der Lötzone 12 wird ein rasches Erhitzen bis über die Schmelztemperatur Tₛ aufgrund der darin vorherrschenden Strahlungsleistungsdichte und durch Anblasen der Platinenunterseite ein schnelles Abkühlen nach der Lötzone erreicht.

Um eine Vorrichtung zum Auflöten von Bauelementen auf Platinen, insbesondere eines vorbeschriebenen Lotofens zu justieren, das heißt, die Parameter für einen optimalen Lötvorgang zu finden und einzustellen, wird die Meßplatine 18' unter dem Strahlungsfeld der Vorwärmzone 10 positioniert. Von einem Regelgerät, beispielsweise einem Computer, wird ein mit der Zeit ansteigender Temperatursollwert vorgegeben. Diesem Temperatursollwert sollte die Temperatur der zu verlötenden Platinen 18 beim späteren Lötvorgang folgen. Hierzu wird die Strahlungsleistung der Infrarotstrahler 22 beziehungsweise 60, 62 auf einen Anfangswert eingestellt die Temperatur auf der Meßplatine 18' vom Sensor 54 aufgenommen und mit dem Temperatursollwert verglichen. Treten Abweichungen der aufgenommenen Temperatur vom Temperatursollwert auf, so wird die Strahlungsleistung der Infrarotstrahler 22 beziehungsweise 60, 62 bei zu niedrig gemessener Temperatur erhöht und bei zu hoher Temperatur zurückgenommen. Die während der verstreichenden Zeit abgegebene Strahlungsleistung wird aufgenommen und daraus ein zeitlicher Mittelwert abgeleitet.

Die Strahlungsleistung kann beispielsweise über die zugeführte elektrische Energie ermittelt werden oder durch einen im Lötofen angeordneten weiteren Sensor 56, insbesondere einem Infrarotdetektor, aufgenommen werden.

Die Grundeinstellung der Lötvorrichtung kann dann aus den geometrischen Daten - die Gesamtlänge der Lötvorrichtung dividiert durch die maximale Verweildauer jeder Platine 18 in der Lötvorrichtung ergibt die Transportgeschwindigkeit - und dem abgeleiteten Mittelwert, als Einstellgröße für die Strahlungsleistung der Infrarotstrahler 22, 24, beziehungsweise 60, 62, 64, 66 ermittelt werden. Wird die Verweildauer verkürzt, muß der Mittelwert bzw. die Strahlungsleistung entsprechend angehoben werden.

Der vom Regelgerät vorzugebende, mit der Zeit ansteigende Temperaturverlauf ergibt sich ebenfalls aus der zu erreichenden Temperaturerhöhung in Abhängigkeit von der Verweildauer der Platinen 18 innerhalb der Vorheizzone 10. Dieser muß nicht zwangsläufig linear sein, sondern kann aufgrund von Abstrahlverlusten oder Gasturbulenzen auch andere zeitliche Verläufe aufweisen.

Das vorgenannte Justierverfahren eignet sich besonders für homogene Strahlungsleistungsdichten innerhalb einer Zone 10, 12. Bei Lötöfen, die keine homogene Leistungsdichteverteilung aufweisen, kann vorteilhaft das nachfolgend beschriebene Verfahren zur Justierung eingesetzt werden.

Eine Meßplatine 18' wird mittels der Transportbänder 16 durch mindestens die Vorwärmzone 10 oder auch die Lötzone 12 bewegt. Bei vorgegebener Strahlleistung der Infrarotstrahler 22 bzw. 24 erhöht sich die Temperatur auf der Meßplatine 18'. Diese vom Sensor 54 aufgenommene Temperatur wird mit einem von einem Regelgerät vorgegebenen, mit der Zeit ansteigenden Temperatursollwert verglichen. Bei Abweichungen wird die Strahlleistung entsprechend nachgeregelt. Der Sensor 56 nimmt die Strahlleistung auf und leitet sie an das Regelgerät oder einen separaten Computer weiter, in welchem ein Mittelwert gebildet wird.

Die Einstellparameter ergeben sich für die Transportgeschwindigkeit aus der Länge des Ofens dividiert durch die maximale Verweildauer einer Platine 18 im Ofen und die Strahlleistung der Infrarotstrahler 22, 60, 62 bzw. 24, 64, 66 aus dem ermittelten Mittelwert bzw. den ermittelten Mittelwerten, wenn mehrere Meßplatinen 18' eingesetzt werden. Der mit der Zeit ansteigende Temperatursollwert ergibt sich aus der benötigten Temperaturerhöhung jeder Platine 18 innerhalb der Verweilzeit einer Platine 18 in einer Zone 10, 12. Auch hier muß der Temperatursollwert nicht zwangsläufig linear ansteigen.

Werden mehrere die Temperatur auf jeder Meßplatine 18' aufnehmende Sensoren 54 derart angeordnet, daß mindestens die höchste und niederste während eines Lötprozesses auftretende Temperatur erfaßt wird, kann aus der ermittelten Temperaturdifferenz erkannt werden, ob die Gefahr der Überhitzung für einzelne Platinenbereiche besteht. Mindestens diese Bereiche werden dann von unten mit einem kühlenden Gas angeblasen.

Mit dem sich im Ofen befindenden Sensor 56 kann mittels des Regelgerätes oder eines Computers eine Regelung für die Strahlungsleistung während jedes Lötprozesses aufgebaut werden. Es ist auch denkbar, die beschriebenen Verfahren zur Justierung eines Lötofens während des kontinuierlichen Lötprozesses durchzuführen. Dazu müßte jede zu verlötende Platine 18 einen Sensor 54 aufweisen, der beispielsweise vor dem Eintritt der Platinen in den Lötofen aufgebracht und hinterher wieder entnommen wird. Auf diese Weise kann aus den Daten der Vorwärmzone 10 auf die benötigte Strahlleistung für die Lötzone 12 geschlossen werden. Durch den Einsatz schnellregelbarer Quarzstrahler kann aber auch eine Regelung innerhalb einer Zone 10, 12 erfolgen.

## Patentansprüche

1. Vorrichtung zum Auflöten von Bauelementen auf Platinen (18), mit mindestens einer Vorwärmzone (10) und einer Lötzone (12), mit einer Transporteinrichtung (20), mittels der die Platinen (18) von einer Zone (10, 12) zur nächsten bewegbar sind sowie mit in der Vorwärmzone (10) sich in Transportrichtung (20) erstreckenden Infrarotstrahlern (22) und in der Lötzone (12) sich quer zur Transportrichtung (20) erstreckenden Infrarotstrahlern (24), dadurch gekennzeichnet, daß die Infrarotstrahler (22, 24) mit ihrer Hauptstrahlachse (26) schräg auf die Platinenoberfläche strahlen.

2. Vorrichtung zum Auflöten vor Bauelementen auf Platinen (18), mit mindestens einer Vorwärmzone (10) und einer Lötzone (12), mit einer Transporteinrichtung (20), mittels der die Platinen (18) von einer Zone (10, 12) zur nächsten bewegbar sind, dadurch gekennzeichnet, daß in der Vorwärmzone (10) und in der Lötzone (12) sich im Winkel von vorzugsweise 45° zur Transportrichtung (20) erstreckende Infrarotstrahler (60, 62, 64, 66) so angeordnet sind, daß sich die Längsachsen der Infrarotstrahler (60, 62, 64, 66) kreuzen und daß die Infrarotstrahler (60, 62, 64, 66) mit ihrer Hauptstrahlachse (26) schräg auf die Platinenoberfläche strahlen.

3. Vorrichtung nach Anspruch 1 oder 2, dadurch gekennzeichnet, daß die Achse (26, 42) der Strahlrichtung der Infrarotstrahler (22, 24, 60, 62, 64, 66) mit der Platinenenormalen (28) einen Winkel (32, 44) zwischen 45 und 75 Grad, vorzugsweise einen Winkel von 65 Grad, einschließt.

4. Vorrichtung nach Anspruch 1, 2 oder 3, dadurch gekennzeichnet, daß die Infrarotstrahler (22, 24, 60, 62, 64, 66) einen rückseitigen Reflektor (46) aufweisen.

5. Vorrichtung nach einem der Ansprüche 1 bis 4, dadurch gekennzeichnet, daß als Infrarotstrahler (22, 24, 60, 62, 64, 66) schnell regelbare Quarzstrahler verwendet werden.

6. Vorrichtung nach einem der vorhergehenden Ansprüche, dadurch gekennzeichnet, daß Mittel (48, 50) zum Zuführen von Gas vorbestimmter Temperatur vorgesehen sind.

7. Vorrichtung nach einem der vorhergehenden Ansprüche dadurch gekennzeichnet, daß die Transporteinrichtung (16) und/oder die Wände (14) auf einer vorbestimmten Temperatur gehalten sind.

8. Vorrichtung nach einem der vorhergehenden Ansprüche, dadurch gekennzeichnet, daß mindestens ein die Temperatur der Platine (18) und ein die Strahlungsleistung erfassender Sensor (54, 56) vorgesehen ist.

9. Verfahren zum Auflöten von Bauelementen auf Platinen (18), mit mindestens einer Vorwärmzone (10) und einer Lötzone (12) sowie einer Transporteinrichtung (20), mittels der die Platinen (18) von einer Zone (10, 12) zur nächsten bewegbar sind, dadurch gekennzeichnet, daß in der Vorwärmzone (10) und in der Lötzone (12) Infrarotstrahler so angeordnet sind, daß sie mit ihrer Hauptstrahlachse (26) schräg auf die Platinenoberfläche strahlen, daß eine Meßplatine (18'), die mindestens einen die Temperatur aufnehmenden Sensor (54) aufweist, unter dem Strahlungsfeld einer Zone (10, 12) positioniert, von einem Regelgerät ein mit der Zeit ansteigender Temperatursollwert vorgegeben, die Srahlungsleistung auf einen Anfangswert eingestellt und die vom Sensor (54) aufgenommene Temperatur auf der Meßplatine (18') mit dem Temperatursollwert verglichen wird und bei Abweichungen eine Nachregelung der Strahlungsleistung erfolgt, daß ferner die Strahlungsleistung erfaßt und ein Mittelwert aus der erfaßten Strahlungsleistung gebildet wird und mit Hilfe dieses Mittelwerts die Parameter, wie Strahlungsleistung und Transportgeschwindigkeit, für einen kontinuierlichen Durchlauf bestimmt werden.

10. Verfahren zum Auflöten von Bauelemente auf Platinen (18), mit mindestens einer Vorwärmzone (10) und einer Lötzone (12) sowie einer Transporteinrichtung (20), mittels der die Platinen (18) von einer Zone (10, 12) zur nächsten bewegbar sind, dadurch gekennzeichnet, daß in der Vorwärmzone (10) und in der Lötzone (12) Infrarotstrahler so angeordnet sind, daß sie mit ihrer Hauptstrahlachse (26) schräg auf die Platinenoberfläche strahlen, daß eine Meßplatine (18'), die mindestens einen die Temperatur aufnehmenden Sensor (54) aufweist, durch mindestens die Vorwärmzone (10) bewegt, ein mit der Zeit ansteigender Temperatursollwert von einem Regelgerät vorgegeben, die Strahlungsleistung auf einen Anfangswert eingestellt, während der Bewegung der Meßplatine (18) durch mindestens die Vorwärmzone (10) die Temperatur auf der Meßplatine (18) erfaßt, mit dem Temperatursollwert verglichen und bei Abweichungen die Strahlungsleistung vom Regelgerät entsprechend geändert wird, daß ferner die Strahlungsleistung erfaßt und ein Mittelwert aus der erfaßten Strahlungsleistung gebildet wird und mit Hilfe dieses Mittelwerts die Parameter, wie Strahlungsleistung und Transportgeschwindigkeit, für einen kontinuierlichen Durchlauf bestimmt werden.

11. Verfahren nach Anspruch 9 oder 10, dadurch gekennzeichnet daß die Meßplatine (18') mindestens zwei die Temperatur erfassende Sensoren (54) aufweist, wobei einer am Ort höchster Temperatur und einer am Ort niederster Temperatur angeordnet ist.

12. Verfahren nach Anspruch 9, 10 oder 11, dadurch gekennzeichnet, daß die Strahlungsleistung von einem in der Vorrichtung angeordneten Sensor (56) aufgenommen wird.

## Claims

1. Device for soldering components onto printed circuit boards (18), having at least one preheating zone (10) and one soldering zone (12), having a transport device (20), by means of which the printed circuit boards (18) can be moved from one zone (10, 12) to the next, and having infrared lamps (22) extending in the transport direction (20) in the preheating zone (10), and infrared lamps (24) extending transversely to the transport direction (20) in the soldering zone (12), characterized in that the infrared lamps (22, 24) radiate with their main beam axis (26) oblique to the printed circuit board surface.

2. Device for soldering components onto printed circuit boards (18), having at least one preheating zone (10) and one soldering zone (12), having a transport device (20), by means of which the printed circuit boards (18) can be moved from one zone (10, 12) to the next, characterized in that infrared lamps (60, 62, 64, 66) extending at an angle of preferably 45° to the transport direction (20) in the preheating zone (10) and in the soldering zone (12) are arranged in such a way that the longitudinal axes of the infrared lamps (60, 62, 64, 66) intersect and the infrared lamps (60, 62, 64, 66) radiate with their main beam axis (26) oblique to the printed circuit board surface.

3. Device according to Claim 1 or 2, characterized in that the axis (26, 42) of the beam direction of the infrared lamps (22, 24, 60, 62, 64, 66) includes an angle (32, 44) of between 45 and 75°, preferably an angle of 65°, with the printed circuit board normal (28).

4. Device according to Claim 1, 2 or 3, characterized in that the infrared lamps (22, 24, 60, 62, 64, 66) have a rear reflector (46).

5. Device according to one of Claims 1 to 4, characterized in that fast-adjustment quartz lamps are used as infrared lamps (22, 24, 60, 62, 64, 66).

6. Device according to one of the preceding claims, characterized in that means (48, 50) are provided for supplying gas of predetermined temperature.

7. Device according to one of the preceding claims, characterized in that the transport device (16) and/or the walls (14) are maintained at a predetermined temperature.

8. Device according to one of the preceding claims, characterized in that at least one sensor (54) detecting the temperature of the printed circuit board (18) and one (56) detecting the radiation power are provided.

9. Method for soldering components onto printed circuit boards (18), having at least one preheating zone (10) and one soldering zone (12), and a transport device (20), by means of which the printed circuit boards (18) can be moved from one zone (10, 12) to the next, characterized in that infrared lamps are arranged in the preheating zone (10) and in the soldering zone (12) in such a way that they radiate with their main beam axis (26) oblique to the printed circuit board surface, in that a measuring board (18'), which has at least one sensor (54) that detects the temperature, is positioned under the radiation field of a zone (10, 12), a temperature set-point value that increases with time is predetermined by a control instrument, the radiation power is set to an initial value and the temperature on the measuring board (18') detected by the sensor (54) is compared with the temperature set-point value, and, in the event of differences, feedback control on the radiation power is carried out, in that the radiation power is furthermore recorded and a mean value is formed from the recorded radiation power, and with the aid of this mean value the parameters such as radiation power and transport rate are determined for continuous throughput.

10. Method for soldering components onto printed circuit boards (18), having at least one preheating zone (10) and one soldering zone (12), and a transport device (20), by means of which the printed circuit boards (18) can be moved from one zone (10, 12) to the next, characterized in that infrared lamps are arranged in the preheating zone (10) and in the soldering zone (12) in such a way that they radiate with their main beam axis (26) oblique to the printed circuit board surface, in that a measuring board (18'), which has at least one sensor (54) that detects the temperature, is moved at least through the preheating zone (10), a temperature set-point value that increases with time is predetermined by a control instrument, the radiation power is set to an initial value, the temperature on the measuring board (18) is recorded during the movement of the printed circuit board (18) through at least the preheating zone (10), is compared with the temperature set-point value, and, in the event of differences, the radiation power is correspondingly altered by the control instrument, in that the radiation power is furthermore recorded and a mean value is formed from the recorded radiation power, and with the aid of this mean value the parameters such as radiation power and transport rate are determined for continuous throughput.

11. Method according to Claim 9 or 10, characterized in that the measuring board (18') has at least two sensors (54) that detect the temperature, one being arranged at the highest-temperature site and one at the lowest-temperature site.

12. Method according to Claim 9, 10 or 11, characterized in that the radiation power is detected by a sensor (56) arranged in the device.

## Revendications

1. Dispositif de soudage de composants sur des platines (18) avec au moins une zone de préchauffage (10) et une zone de brasage (12) une installation de transport (20) qui déplace les platines (18) d'une zone (10, 12) à la suivante ainsi que des radiateurs infrarouges (22) placés dans la direction de transport (20) au niveau de la zone de préchauffage (10) et des radiateurs infrarouges (24) placés transversalement à la direction de transport (20) dans la zone de brasage (12), caractérisé en ce que les radiateurs infrarouges (22, 24) rayonnent avec leur axe de rayonnement principal (26) dirigé en biais vers la surface des platines.

2. Dispositif pour souder des composants sur des platines (18) comprenant au moins une zone de préchauffage (10) et une zone de brasage (12), une installation de transport (20) déplaçant les platines (18) d'une zone (10, 12) à la suivante, caractérisé en ce que dans la zone de préchauffage (10) et la zone de brasage (12), il y a des radiateurs infrarouge (60, 62, 64, 66) qui font un angle de préférence égal à 45 degrés par rapport à la direction de transport (20) de façon que les axes longitudinaux des radiateurs infrarouge (60,62, 64,66) se croissent et que les radiateurs infrarouge (60,62, 64, 66) émettent avec leur axe principal de rayonnement (26) dirigé en biais vers la surface supérieure des platines.

3. Dispositif selon les revendications 1 ou 2, caractérisé en ce que l'axe (26, 42) de la direction de rayonnement des radiateurs infrarouge (22, 24, 60, 62, 64, 66) fait avec la normale (28) aux platines, un angle (32, 44) compris entre 45 et 75 degrés et de préférence un angle de 65 degrés.

4. Dispositif selon les revendications 1, 2, ou 3, caractérisé en ce que les radiateurs infrarouge (22, 24, 60, 62, 64, 66) sont équipés d'un réflecteur arrière (46).

5. Dispositif selon l'une des revendications 1 à 4, caractérisé en ce que les radiateurs infrarouge (22, 24, 60, 62, 64, 66) sont des radiateurs à quartz à réglage rapide.

6. Dispositif selon les revendications précédentes, caractérisé par des moyens (48, 50) pour fournir du gaz à une température prédéterminée.

7. Dispositif selon les revendications précédentes, caractérisé en ce que la direction de transport (16) et/ou les parois (14) sont maintenues à une températures prédéterminée.

8. Dispositif selon les revendications précédentes, caractérisé par au moins un capteur (54, 56) mesurant la température de la platine (18) et captant la puissance de rayonnement.

9. Procédé pour souder des composants sur des platines (18) avec au moins une zone de préchauffage (10) et une zone de brasage (12) ainsi qu'une installation de transport (20) déplaçant les platines (18) d'une zone (10, 12) à la suivante, caractérisé par des radiateurs infrarouge prévus dans la zone de préchauffage (10) et la zone de brasage (12), et dont l'axe de rayonnement principal (26) est dirigé en biais vers la surface supérieure des platines, une platine de mesure (18') comportant au moins un capteur de température (54) étant placée sous le champ de rayonnement d'une zone (10, 12) un appareil de réglage prédéterminant une température de consigne croissante avec le temps et réglant la puissance de rayonnement à une valeur initiale et la température reçue par le capteur (54) sur la platine de mesure (18') est comparée à la température de consigne et en cas de différence, on asservit la puissance de rayonnement, et en outre on détecte la puissance de rayonnement et on forme une valeur moyenne à partir de la puissance de rayonnement détectée et à l'aide de cette valeur moyenne on détermine les paramètres tels que la puissance de rayonnement et la vitesse de transport pour un passage continu.

10. Procédé de soudage de composants sur des platines (18) avec au moins une zone de préchauffage (10) et une zone de brasage (12) ainsi qu'une installation de transport (20) déplaçant les platines (18) d'une zone (10, 12) à la suivante, caractérisé en ce que la zone de préchauffage (10) et la zone de brasage (12) comportent des radiateurs infrarouge dont l'axe principal de rayonnement (26) est dirigé en biais vers la surface supérieure des platines, une platine de mesure (18') comportant au moins un capteur de température (54) étant déplacée au moins à travers la zone de préchauffage (10), et une température de consigne croissante avec le temps étant prédéterminée par un appareil de réglage, la puissance de rayonnement étant réglée à une valeur initiale, et pendant le mouvement de la platine de mesure (18') à travers au moins la zone de préchauffage (10), on détecte la température sur la platine de mesure (18') et on la compare à la température de consigne et en cas de différence, l'appareil de réglage modifie de façon correspondante la puissance de rayonnement, et en ce qu'en outre on détecte la puissance de rayonnement et on forme une valeur moyenne à partir de la puissance de rayonnement détectée et à l'aide de cette valeur moyenne on détermine les paramètres tels que la puissance de rayonnement et la vitesse de transport pour un passage continu.

11. Procédé selon la revendication 9 ou 10, caractérisé en ce que la platine de mesure (18') comporte au moins deux capteurs (54) détectant la température, l'un étant prévu à l'emplacement de la température la plus élevée et l'autre à l'emplacement de la température la plus faible.

12. Procédé selon les revendications 9, 10 ou 11, caractérisé en ce que la puissance de rayonnement est reçue par un capteur (56) prévu dans le dispositif.
